# EUROPÄISCHE PATENTANMELDUNG

(11) **EP 4 835 937 A1**
(43) Veröffentlichungstag der Anmeldung: **04.11.2026**
(21) Anmeldenummer: 26170542.0
(22) Anmeldetag: 02.04.2026
(51) Int. Cl.: H01H 19/11, H01H 3/50, G01R 1/04, H01H 9/04, H01H 19/14

(54) **ELEKTRONISCHES MESSGERÄT MIT EINEM UM EINE DREHACHSE VERDREHBAREN WAHLSCHALTER**

(30) Priorität: 28.04.2025 DE 102025116137
(71) Anmelder: Robert Bosch GmbH, 70442 Stuttgart (DE)
(72) Erfinder: Chan, Chi Fung, 73760 Ostfildern (DE); Ying, Jianbang, Hangzhou, Zhejiang, 311400 (CN); Zhang, Xinhui, Hangzhou, 311400 (CN)

(57) **Zusammenfassung**

Die Erfindung bezieht sich auf ein elektronisches Messgerät (10) mit einem um eine Drehachse (30) verdrehbaren Wahlschalter (26) zur Auswahl der Betriebsmodi. Der Wahlschalter (26) ist auf einem Zapfen (36) an einem Gehäuse (24) aufgenommen und mit federbeaufschlagten Rastelementen (50) versehen. Diese arretieren den verdrehbaren Wahlschalter (26) in jeweils einer einem ausgewählten Betriebsmodus entsprechenden Drehlage temporär. Die federbeaufschlagten Rastelemente (50) sind in dem Gehäuse (24) des elektronischen Messgerätes (10) in Horizontallage (60) aufgenommen.

## Beschreibung

### Technisches Gebiet

Die Erfindung bezieht sich auf ein elektronisches Messgerät mit einem um eine Drehachse verdrehbaren Wahlschalter zur Einstellung der Betriebsmodi, der auf einem Zapfen eines Gehäuses aufgenommen und mit federbeaufschlagten Rastelementen versehen ist, die den verdrehbaren Wahlschalter in einer einem ausgewählten Betriebsmodus entsprechenden Drehlage temporär arretieren.

### Stand der Technik

Manuell handhabbare elektronische Messgeräte, wie beispielsweise Multimeter, Voltmeter oder Strommessgeräte, erfordern ein möglichst geringes Gewicht, um die Handhabung durch den Bediener zu vereinfachen. Derartige elektronische Messgeräte weisen in der Regel einen Wahlschalter auf, mit welchem ein Betriebsmodus des elektronischen Messgerätes durch den Bediener manuell ausgewählt werden kann. So kann beispielsweise mittels eines verdrehbaren Schaltrades am elektronischen Messgerät zwischen Spannungsmessung, Strommessung und Widerstandsmessung und der Messung weiterer elektrischer Größen ausgewählt werden.

Derartige an elektronischen Messgeräten vorgesehene Wahlschalter werden über Rastelemente in den jeweils durch den Bediener ausgewählten Positionen temporär arretiert. Der Bediener verdreht den Wahlschalter entsprechend der von ihm gewünschten Position in Umfangsrichtung. Dabei rastet der verdrehbare Wahlschalter in bestimmten Umfangslagen, entsprechend dem ausgewählten Betriebsmodus, ein und bleibt in dieser Umfangslage temporär arretiert.

Zur Bestimmung der jeweils definierten Drehlage und zur Verbesserung der Haptik durch den Bediener ist es erforderlich, dass die ausgewählten Drehlagen eindeutig ausgewählt werden können und kein schwammiges Verhalten auftritt, bei dem die Drehlage des Wahlschalters nicht eindeutig definiert ist. Des Weiteren sollte der verdrehbare Wahlschalter zwischen den einzelnen definierten Drehlagen eindeutig und mit möglichst wenig Reibung verdrehbar sein, um den Bediener bei der Handhabung zu unterstützen.

Derartige, manuell bedienbare elektronische Messgeräte sollten neben einer benutzerfreundlichen Handhabung auch eine geringe Bauhöhe aufweisen, die das Umgreifen und somit eine einhändige Handhabung des elektronischen Messgerätes vereinfachen.

### Offenbarung der Erfindung

Erfindungsgemäß wird ein elektronisches Messgerät mit einem um eine Drehachse verdrehbaren Wahlschalter zur Auswahl der Betriebsmodi vorgeschlagen, wobei der verdrehbare Wahlschalter auf einem Zapfen im Gehäuse aufgenommen ist und mit federbeaufschlagten Rastelementen versehen ist, die den verdrehbaren Wahlschalter in einer einem ausgewählten Betriebsmodus entsprechenden Drehlage temporär arretieren. Die federbeaufschlagten Rastelemente im Gehäuse des elektronischen Messgerätes sind in Horizontallage angeordnet.

Durch die erfindungsgemäß vorgeschlagene Lösung kann erreicht werden, dass die federbeaufschlagten Rastelemente im durch den verdrehbaren Wahlschalter zur Verfügung gestellten Bauraum untergebracht werden können, die Bauhöhe des elektronischen Messgerätes reduziert und dessen Handhabung hinsichtlich des Einstellens definierter Drehlagen des Wahlschalters erheblich verbessert wird.

In vorteilhafter Weiterbildung des erfindungsgemäß vorgeschlagenen elektronischen Messgerätes sind die federbeaufschlagten Rastelemente radial an eine Innenprofilierung des verdrehbaren Wahlschalters angestellt. Die Anordnung der federbeaufschlagten Rastelemente im durch das Innere des verdrehbaren Wahlschalters gebildeten Hohlraum reduziert die Bauhöhe des Gehäuses des erfindungsgemäß vorgeschlagenen elektronischen Messgeräts nicht unerheblich.

In einer alternativen Ausführungsvariante des erfindungsgemäß vorgeschlagenen elektronischen Messgerätes sind die federbeaufschlagten Rastelemente radial am Außenumfang einer Hülse auf der Innenseite des verdrehbaren Wahlschalters angestellt. Auch hier sind die federbeaufschlagten Rastelemente in Horizontallage angeordnet, wobei sich analog zur vorstehend skizzierten Ausführungsvariante eine erhebliche Verringerung der Bauhöhe des erfindungsgemäß vorgeschlagenen elektronischen Messgerätes erreichen lässt.

In einer vorteilhaften Weiterbildung des erfindungsgemäß vorgeschlagenen elektronischen Messgerätes sind die federbeaufschlagten Rastelemente in Aufnahmehülsen eingelassen, die im Gehäuse des elektronischen Messgerätes in einem Hülsenkäfig aufgenommen sind. Des Weiteren ist beim erfindungsgemäß vorgeschlagenen elektronischen Messgerät vorgesehen, dass die federbeaufschlagten Rastelemente als Arretierkugeln ausgeführt sind.

Das erfindungsgemäß vorgeschlagene elektronische Messgerät zeichnet sich ferner dadurch aus, dass die Innenprofilierung des Wahlschalters in alternierender Abfolge angeordnete Vertiefungen und gerundete Erhebungen aufweist. Eine derartig ausgebildete Innenprofilierung bietet den Vorteil, dass die Vertiefungen einerseits definierte Drehlagen bestimmen, sobald das federbeaufschlagte Rastelement in diese eingreift. Die alternierend vorgesehenen, jeweils zwischen Vertiefungen angeordneten gerundeten Erhebungen ermöglichen andererseits ein haptisch angenehmes Weiterschalten des verdrehbaren Wahlschalters von einer Drehlage in die nächste.

In einer weiteren vorteilhaften Ausführungsvariante des erfindungsgemäß vorgeschlagenen elektronischen Messgerätes ist zwischen dem verdrehbaren Wahlschalter und dem Gehäuse eine Labyrinthdichtung ausgeführt. Die Labyrinthdichtung umfasst mindestens eine gehäuseseitig angeordnete Kriechstrecke sowie mindestens eine wahlschalterseitige, ringförmig ausgebildete Kriechstrecke, deren jeweilige Umfangsflächen, bezogen auf die Vertikale, geneigt ausgeführt sind. Durch die Ausbildung der Labyrinthdichtung kann das Eindringen von Kontaminationen, wie Feuchtigkeit oder Schmutzpartikel,durch den Freiraum zwischen dem verdrehbaren Wahlschalter und dem Gehäuse wirksam verhindert werden.

Zudem ist in einer weiterführenden Ausführungsvariante des erfindungsgemäß vorgeschlagenen elektronischen Messgerätes vorgesehen, dass zumindest der gehäuseseitig ausgebildeten ringförmigen Kriechstrecke eine ringförmige Dichtung zugeordnet ist.

Ferner zeichnet sich das erfindungsgemäß vorgeschlagene elektronische Messgerät dadurch aus, dass die Innenprofilierung in die wahlschalterseitig ausgeführte Kriechstrecke des verdrehbaren Wahlschalters integriert ist. Des Weiteren sind beim erfindungsgemäß vorgeschlagenen elektronischen Messgerät gehäuseseitig zumindest einander in 180°-Anordnung gegenüberliegende, federbeaufschlagte Rastelemente vorgesehen.

### Vorteile der Erfindung

Durch die erfindungsgemäß vorgeschlagene Ausbildung des elektronischen Messgerätes lässt sich dieses einfacher handhaben, da aufgrund der flachen Bauweise des verdrehbaren Wahlschalters eine geringere Bauhöhe des manuell handhabbaren elektronischen Messgerätes erreicht werden kann. In vorteilhafter Weise wird das durch den verdrehbaren Wahlschalter gebildete Volumen im Inneren des verdrehbaren Wahlschalters zur Anordnung der federbeaufschlagten Rasterelemente in horizontaler Lage ausgenutzt. Des Weiteren können im Hohlraum des verdrehbaren Wahlschalters, aufgenommen in einem Hülsenkäfig, die federbeaufschlagten Rastelemente, ausgeführt als Arretierkugeln, in einer 180°-Anordnung einander gegenüberliegend angeordnet werden. Anstelle von beispielsweise zwei einander gegenüberliegend angeordneten federbeaufschlagten Rastelementen könnten auch mehrere, beispielsweise drei Aufnahmehülsen für federbeaufschlagte Rastelemente in einer 120°-Anordnung im Inneren des verdrehbaren Wahlschalters untergebracht werden.

Durch die erfindungsgemäß vorgeschlagene Lösung kann zwischen dem auf einen Zapfen des Gehäuses aufsetzbaren verdrehbaren Wahlschalter und dem Gehäuse eine Labyrinthdichtung gebildet werden. Die Labyrinthdichtung wird einerseits durch mindestens eine gehäuseseitig vorgesehene ringförmige Kriechstrecke und andererseits durch mindestens eine im Inneren des verdrehbaren Wahlschalters untergebrachte, wahlschalterseitig ausgebildete, ringförmige Kriechstrecke gebildet. In vorteilhafter Weise kann in diese im Inneren des verdrehbaren Wahlschalters ausgebildete Kriechstrecke die Innenprofilierung integriert werden.

Die Innenprofilierung umfasst in alternierender Abfolge vorgesehene Vertiefungen und zwischen diesen befindliche abgerundete Erhebungen. In die Vertiefungen greifen die federbeaufschlagten Rastelemente, ausgeführt als Arretierkugeln, in einer durch den Bediener ausgewählten Drehlage ein, welche einem ausgewählten Betriebsmodus des elektronischen Messgerätes entspricht. Durch die gerundeten Erhebungen wird ein haptisch angenehmes Weiterschalten des verdrehbaren Wahlschalters von einer Drehlageposition in die nächste sichergestellt.

In alternativer Ausführung des erfindungsgemäß vorgeschlagenen elektronischen Messgerätes lässt sich die Innenprofilierung auch als Außenprofilierung am Außenumfang einer an der Innenseite des verdrehbaren Wahlschalters angespritzten Hülse ausbilden. Auch in diesem Fall können die federbeaufschlagten Rastelemente in Form von mit Spiralfedern ausgebildeten Arretierkugeln in Horizontallage angeordnet werden, was besonders günstig hinsichtlich der erzielbaren Bauhöhe des Gehäuses des erfindungsgemäß vorgeschlagenen elektronischen Messgerätes ist.

Bei geeigneter Ausbildung des verdrehbaren Wahlschalters, vorzugsweise mittels des Spritzgießverfahrens, kann dieser auch an anderen elektronischen Geräten zum Einsatz kommen, bei welchen mittels eines verdrehbaren Wahlschalters verschiedene Betriebspositionen temporär zu arretieren sind.

Des Weiteren wird insbesondere durch Ausbildung der vorstehend beschriebenen Labyrinthdichtung dem Umstand Rechnung getragen, dass elektrische und elektronische Geräte und Betriebsmittel, je nach Aufstellort und Einsatzbedingungen vor dem Eindringen von Schmutz, Staub, Wasser o. ä. zu schützen sind, um die Gefährdung von Personen oder den Ausfall des Gerätes zu verhindern. Somit sind die einschlägigen Vorschriften hinsichtlich der IP-Schutzarten, die an das erfindungsgemäß vorgeschlagene elektronische Messgerät gestellt sind, allesamt erfüllt.

### Kurze Beschreibung der Zeichnungen

Ausführungsformen der Erfindung werden anhand der Zeichnungen und der nachfolgenden Beschreibung näher erläutert.

Es zeigen:
- Figur 1 und 2: perspektivische Ansichten von elektronischen Messgeräten,
- Figur 3: eine perspektivische Darstellung der Innenseite eines scheibenförmig ausgebildeten verdrehbaren Wahlschalters,
- Figur 4: einen Schnitt durch ein Gehäuse eines elektronischen Messgerätes mit einem auf einen Zapfen aufgesetzten verdrehbaren Wahlschalter gemäß Figur 3,
- Figur 5: ein teilweise transparent dargestellter verdrehbarer Wahlschalter oberhalb eines Hülsenkäfigs im Gehäuse des elektronischen Messgerätes und
- Figur 6: eine perspektivische Darstellung des Gehäuses des elektronischen Bauelements ohne verdrehbaren Wahlschalter und Darstellung der gehäuseseitigen Aufbauten unterhalb des verdrehbaren Wahlschalters.

### Ausführungsformen der Erfindung

In der nachfolgenden Beschreibung der Ausführungsformen der Erfindung werden gleiche oder ähnliche Elemente mit gleichen Bezugszeichen bezeichnet, wobei auf eine wiederholte Beschreibung dieser Elemente in Einzelfällen verzichtet wird. Die Figuren stellen den Gegenstand der Erfindung nur schematisch dar.

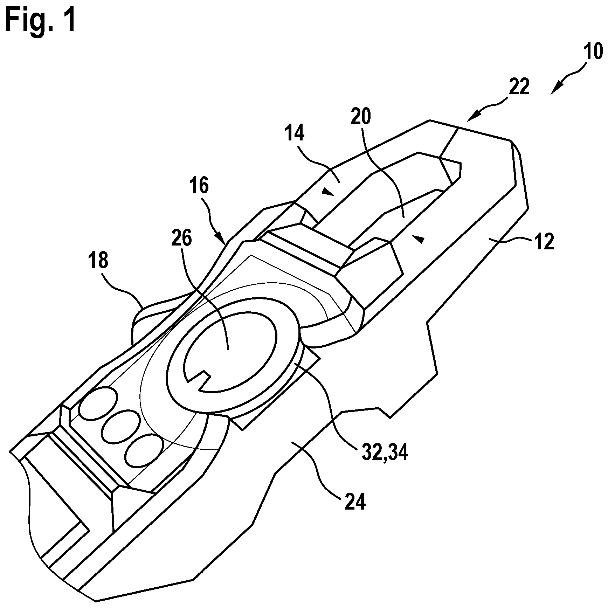

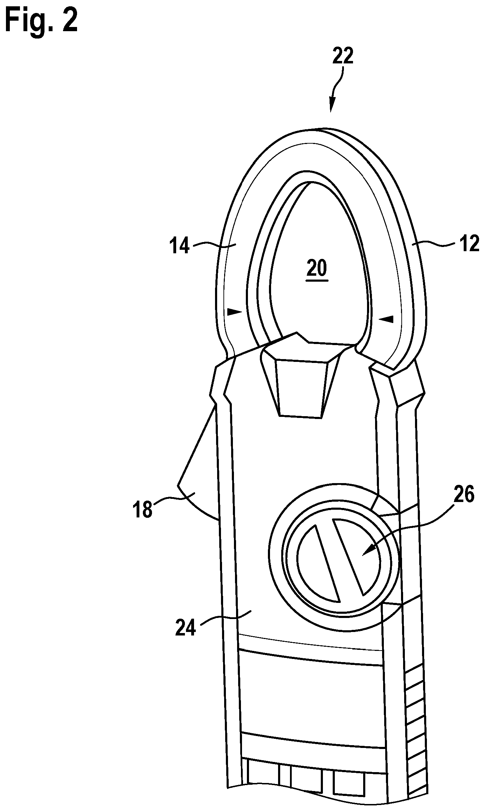

Die Figuren 1 und 2 zeigen elektronische Messgeräte 10, jeweils in perspektivischer Darstellung.

Der Darstellung gemäß Figur 1 ist ein elektronisches Messgerät 10 zu entnehmen, welches einen stationären Schenkel 12 sowie einen relativ zu diesem bewegbaren Schenkel 14 aufweist. Der bewegbare Schenkel 14 ist um ein Gelenk 16 bewegbar. Am elektronischen Messgerät 10 befindet sich seitlich ferner ein Auslöser 18, mit welchem der Betrieb des elektronischen Messgerätes 10 aktiviert werden kann. Das elektronische Messgerät 10 kann als Multimeter, als Zangenamperemeter, als Gabelamperemeter oder als Spannungsprüfer zur Messung elektrischer Größen, wie Ströme, Spannungen, ohmsche Widerstände, Kapazitäten, Temperaturen und/oder Impedanzen, in Gleichstrom- und Wechselstromanwendungen ausgeführt sein. In der in Figur 1 dargestellten geschlossenen Position 22 des stationären Schenkels 12 und des bewegbaren Schenkels 14 begrenzen diese ein Auge 20 beziehungsweise einen Freiraum, durch welchen sich ein stromführender oder ein spannungsführender elektrischer Leiter zur kontaktlosen Messung elektrischer Größen erstreckt. Das elektronische Messgerät 10 umfasst ein Gehäuse 24, in dem eine Auswerteelektronik sowie ein Display und dergleichen untergebracht sind, ebenso wie eine Energiequelle in Gestalt einer Batterie oder eines wiederaufladbaren Akkumulators oder eines Akkupacks, bestehend aus mehreren wiederaufladbaren Akkumulatoren. Auf der in der perspektivischen Darstellung gemäß Figur 1 dargestellten Gehäuseoberseite befindet sich ein verdrehbarer Wahlschalter 26. Der verdrehbare Wahlschalter 26 umfasst einen Außenumfang 32, welcher mit einer Profilierung 34 versehen ist, so dass der verdrehbare Wahlschalter 26 in Umfangsrichtung um eine Drehachse 30 verdreht werden kann, um zwischen verschiedenen Betriebsmodi des elektronischen Messgerätes 10 hin und her zu schalten. Die Profilierung 34 ist am Außenumfang des verdrehbaren Wahlschalters 26 so beschaffen, dass diese auch mit einem Schutzhandschuh betätigt werden kann. Der verdrehbare Wahlschalter 26 ist um die Drehachse 30 verdrehbar und nimmt verschiedene Drehlagen ein, d. h. verschiedene Rastpositionen in seiner Drehbewegung um die Drehachse 30, die einem jeweils durch den Bediener ausgewählten Betriebsmodus des elektronischen Messgerätes 10 entsprechen.

Der Draufsicht gemäß Figur 2 ist ein elektronisches Messgerät 10 zu entnehmen, dessen stationärer Schenkel 12 und dessen bewegbarer Schenkel 14 ebenfalls eine geschlossene Position 22 einnehmen und ein Auge 20 begrenzen. Der auf der Vorderseite des elektronischen Messgerätes 10 dargestellte verdrehbare Wahlschalter 26 ist in eine Anzahl von Drehlagen, die entsprechenden Betriebsmodi zugeordnet sind, verdrehbar. So kann das elektronische Messgerät 10 zur Widerstandsmessung, zur Gleich- oder Wechselspannungsmessung und auch zur Messung von Strömen eingesetzt werden.

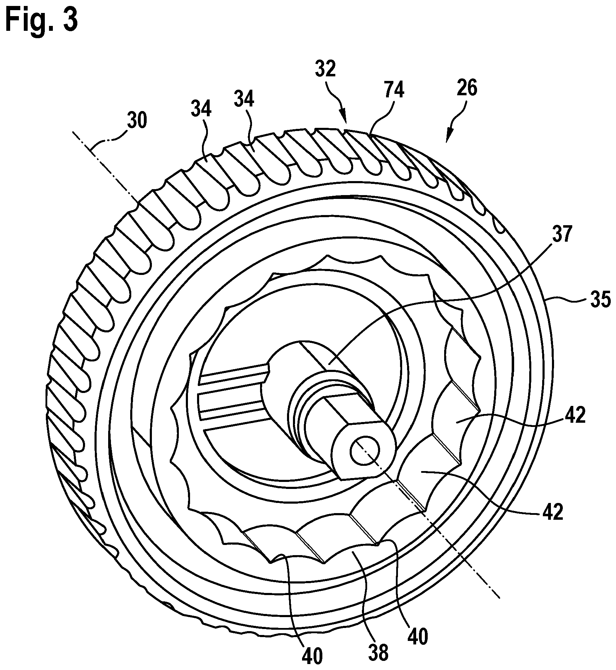

Figur 3 zeigt in perspektivischer Ansicht eine Innenseite des verdrehbaren Wahlschalters 26. Dieser ist bevorzugt als Kunststoffspritzgussbauteil gefertigt und umfasst eine sich entlang seines Außenumfangs 32 erstreckende, relativ grobe Profilierung 34. Dadurch ist sichergestellt, dass der verdrehbare Wahlschalter 26 auch beispielsweise mit Schutzhandschuhen o. ä. in Umfangsrichtung um die Drehachse 30 problemlos bewegt werden kann. Der verdrehbare Wahlschalter 26 umfasst eine an seine Innenseite angespritzte Hülse 35, deren Außenumfang mit Bezugszeichen 37 bezeichnet ist. Des Weiteren erstreckt sich an der Innenseite des als Kunststoffspritzgussbauteil gefertigten verdrehbaren Wahlschalters 26 eine Innenprofilierung 38. Die Innenprofilierung 38 weist in alternierender Abfolge in Ringform angeordnete Vertiefungen 40 sowie gerundete Erhebungen 42 auf. Die Vertiefungen 40 der Innenprofilierung 38 stellen definierte Rastpositionen, d. h. definierte Drehlagen des am elektronischen Messgerät 10 montierten verdrehbaren Wahlschalters 26 und damit den Drehlagen entsprechende Betriebsmodi ein.

Der Darstellung gemäß Figur 3 ist des Weiteren zu entnehmen, dass die Innenprofilierung 38 an einer wahlschalterseitigen Kriechstrecke 74 ausgeführt ist. Die wahlschalterseitige, sich ringförmig erstreckende Kriechstrecke 74 stellt einen Teil einer nachstehend noch zu beschreibenden Labyrinthdichtung 56 dar. Der in Figur 3 in perspektivischer Ansicht von der Innenseite her dargestellte verdrehbare Wahlschalter 26 wird mit seiner Hülse 35 auf einen am Gehäuse 24 des elektronischen Messgerätes 10 angeordneten Zapfen 36 aufgesteckt.

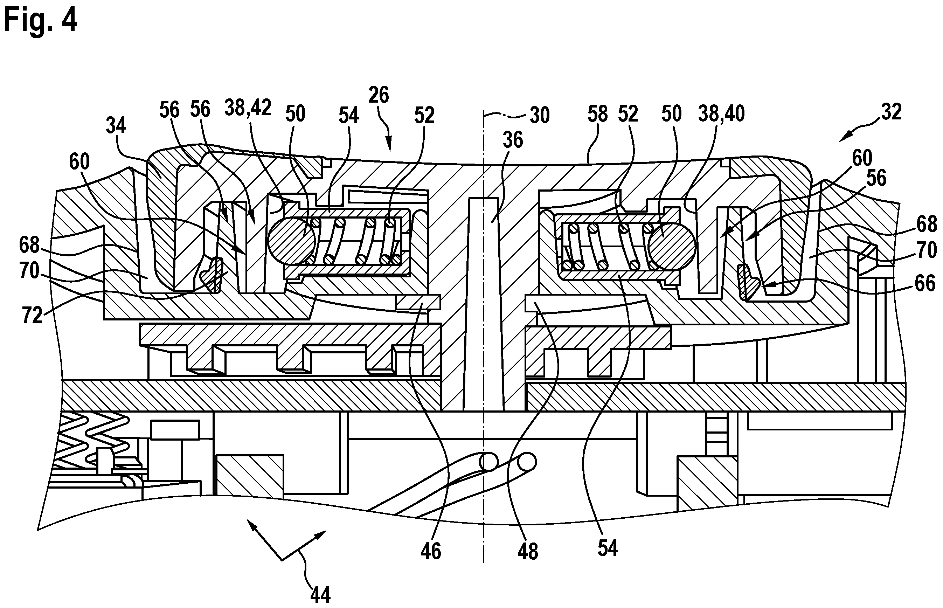

Figur 4 zeigt einen Querschnitt durch das Gehäuse 24 des erfindungsgemäß vorgeschlagenen elektronischen Messgerätes 10 mit montiertem verdrehbarem Wahlschalter 26. Wie Figur 4 zu entnehmen ist, wird der in perspektivischer Ansicht gemäß Figur 3 dargestellte verdrehbare Wahlschalter 26 auf einen Zapfen 36 im Gehäuse 24 des elektronischen Messgerätes 10 aufgesteckt. Über den Zapfen 36 kann beispielsweise ein Potentiometer oder ein anderer elektrischer Positionsgeber betätigt werden. Der Schnittdarstellung gemäß Figur 4 ist zu entnehmen, dass der verdrehbare Wahlschalter 26 am Außenumfang 32 besagte grob ausgebildete Profilierung 34 aufweist. Die Deckelseite des bevorzugt als Kunststoffspritzgießbauteil gefertigten, verdrehbaren Wahlschalters 26 ist mit einer konkaven Wölbung 58 versehen. Die grob ausgebildete Profilierung 34 kann beispielsweise auf den Außenumfang 32 des verdrehbaren Wahlschalters 26 aufgesteckt oder aufgepresst sein. Im Inneren des scheibenförmig ausgebildeten verdrehbaren Wahlschalters 26 ist ein Hohlraum ausgebildet, der gemäß der Darstellung in Figur 4 durch in Horizontallage 60 - hier einander gegenüberliegend - angeordnete, federbeaufschlagte Rastelemente 50 ausgefüllt ist. Unter Horizontallage 60 der federbeaufschlagten Rastelemente 50 ist deren senkrechte Anordnung zur Drehachse 30 des verdrehbaren Wahlschalters 26 zu verstehen. Die Horizontallage 60 ermöglicht eine besonders bauraumsparende Anordnung der federbeaufschlagten Rastelemente 50 unterhalb des verdrehbaren Wahlschalters 26. Die federbeaufschlagten Rastelemente 50, hier als Arretierkugeln ausgebildet, sind jeweils in einer Aufnahmehülse 54 eingelassen. In jeder der Aufnahmehülsen 54 gemäß der Darstellung in Figur 4 befindet sich ein, beispielsweise als Spiralfeder ausgebildetes Federelement 52, welches die federbeaufschlagten Rastelemente 50 in radialer Richtung beaufschlagt, d. h. in die den federbeaufschlagten Rastelementen 50 gegenüberliegenden Innenprofilierungen 38 anstellt. Im vorliegenden Zusammenhang ist unter radialer Richtung zu verstehen, dass die federbeaufschlagten Rastelemente 50, bezogen auf die Drehachse 30, radial nach außen auf die Innenprofilierung 38 wirken. In der Darstellung gemäß Figur 4 ist gezeigt, dass die beiden, hier in einer 180°-Anordnung 64 einander gegenüberliegend angeordneten, federbeaufschlagten Rastelemente 50 in Vertiefungen 40 der Innenprofilierung 38 eingreifen. Die Innenprofilierung 38, wie sie auch in der perspektivischen Darstellung gemäß Figur 3 dargestellt ist, befindet sich an einer wahlschalterseitig, ringförmig vorgesehenen Kriechstrecke 74. Diese sowie eine gehäuseseitige Kriechstrecke 72, ebenfalls ausgebildet in Ringform, bilden im Zusammenspiel eine Labyrinthdichtung 56. Durch die hier dargestellte Labyrinthdichtung 56 wird die Kontamination des Gehäuseinnenraums 44 des erfindungsgemäß vorgeschlagenen elektronischen Messgerätes 10 durch Wasser, leitfähige Partikel, Staub und dergleichen verhindert. Die in Figur 4 dargestellte Labyrinthdichtung 56 dichtet den Innenraum des Gehäuses 24 nach außen ab, ohne dass weitere Dichtelemente erforderlich sind.

Aus der Darstellung gemäß Figur 4 geht hervor, dass die Labyrinthdichtung 56 hier durch die beiden, jeweils in Bezug auf die Vertikale angeschrägte Umfangsflächen aufweisende, gehäuseseitige Kriechstrecke 72 und wahlschalterseitige Kriechstrecke 74 gebildet wird. An der schräg in Bezug auf die Vertikale ausgebildeten äußeren Umfangsfläche der gehäuseseitigen Kriechstrecke 72 ist eine ringförmig ausgebildete Dichtung 66 vorgesehen, welche die Abdichtwirkung unterstützt.

Der verdrehbare Wahlschalter 26, der in einer relativ geringen Bauhöhe ausgebildet ist, was zur Bauhöhenreduktion des elektronischen Messgerätes 10 nicht unerheblich beiträgt, ist mittels eines Sicherungselementes 46, welches in eine Umfangsnut 78 eingreift, in axialer Richtung gesichert.

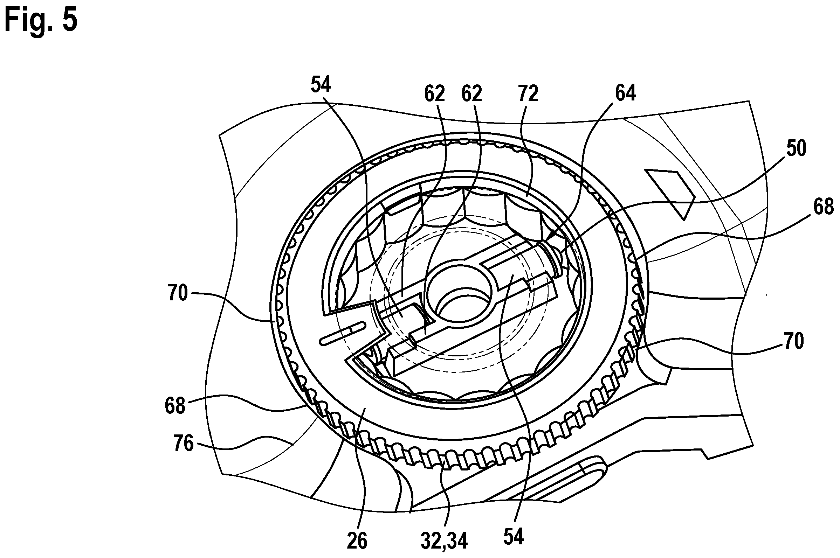

Aus der Darstellung gemäß Figur 4 geht weiterhin hervor, dass die beiden federbeaufschlagten Rastelemente 50, jeweils eingelassen in Aufnahmehülsen 54, hier in einer 180°-Anordnung 64 dargestellt sind (vgl. auch Figur 5). Alternativ besteht die Möglichkeit, auch mehr als zwei einander gegenüberliegende, federbeaufschlagte Rastelemente 50 im Freiraum zwischen der Innenseite des verdrehbaren Wahlschalters 26 und dem Gehäuse 24 des elektronischen Messgerätes 10, beispielsweise in einer sternförmigen Anordnung, in einer 120°-Teilung unterzubringen.

Aus der Darstellung gemäß Figur 4 geht des Weiteren hervor, dass ein Freiraum 70 zwischen der relativ grob ausgeführten Profilierung 34 des verdrehbaren Wahlschalters 26 und einer Gehäusewand 68 des Gehäuses 24 vorliegt, der über die besagte ringförmige Dichtung 66 einerseits sowie die Labyrinthdichtung 56 andererseits nach außen hin abgedichtet ist.

Figur 5 zeigt eine perspektivische Draufsicht auf den im elektronischen Messgerät 10 montierten verdrehbaren Wahlschalter 26. Dieser ist in der Darstellung gemäß Figur 5 transparent dargestellt, so dass erkennbar ist, dass die Aufnahmehülsen 54, die hier in 180°-Anordnung 64 platziert sind, in einem Hülsenkäfig 62 untergebracht sind. Anstelle der in der Draufsicht gemäß Figur 5 dargestellten zwei federbeaufschlagten Rastelemente 50 könnten auch drei oder mehr federbeaufschlagte Rastelemente vorgesehen sein, die jedoch nicht in einer 180°-Anordnung 64, sondern in einer 120°-Teilung oder in einer geringeren Umfangsteilung zu platzieren wären.

Zwischen dem Außenumfang 32 mit grober Profilierung 34 und der Gehäusewand 68 an der Oberseite des Gehäuses 24 des elektronischen Messgerätes 10 erstreckt sich der ringförmige Freiraum 70, der durch besagte Labyrinthdichtung 56 beziehungsweise durch das ringförmige Dichtungselement 66 vor Umwelteinflüssen geschützt ist. Hierdurch können die Anforderungen hinsichtlich des IP-Schutzes, die an elektrische und elektronische Betriebsmittel gestellt werden, erfüllt werden, die vorschreiben, dass ein Gehäuse vor dem Eindringen von Schmutz, Staub, Wasser o. ä. sowie Körperteile oder Gegenstände zu schützen sind, um Gefährdungen von Personen oder den Ausfall des elektronischen Gerätes zu verhindern.

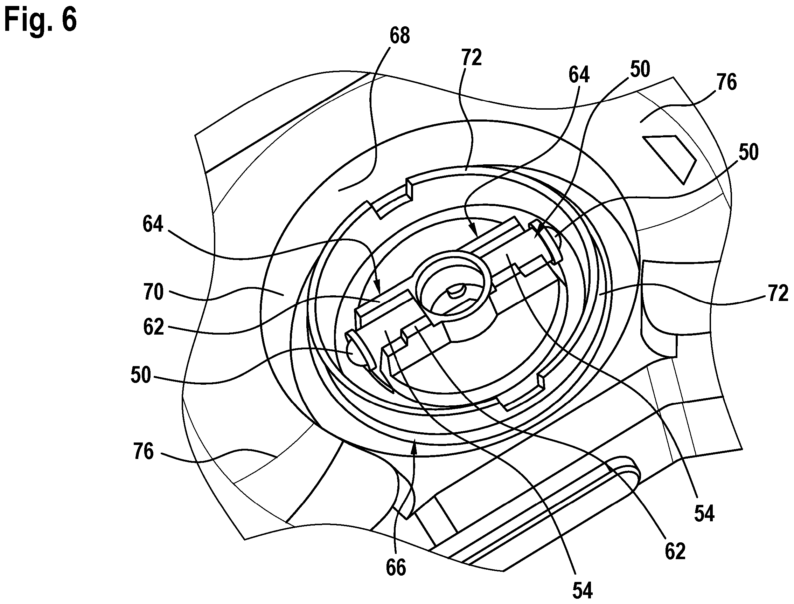

Der Darstellung gemäß Figur 6 ist zu entnehmen, dass bei abgenommenem verdrehbarem Wahlschalter 26 auf der Oberseite des Gehäuses 24 des elektronischen Messgerätes 10 das ringförmig ausgebildete Dichtungselement 66 verläuft. Dieses umschließt die gehäuseseitige Kriechstrecke 72, die hier als ringförmige Rippe ausgebildet ist und den Hülsenkäfig 62 umschließt. Die gehäuseseitige Kriechstrecke 72 stellt in Zusammenschau mit Figur 4 einen Teil der Labyrinthdichtung 56 dar, der durch die gehäuseseitig verlaufende, ringförmige Kriechstrecke 72 einerseits und die an der Innenseite des verdrehbaren Wahlschalters 26 ausgebildete, ebenfalls ringförmige, wahlschalterseitige Kriechstrecke 74 gebildet ist. In die wahlschalterseitig ausgebildete, ebenfalls ringförmig konfigurierte Kriechstrecke 74 ist zudem die Innenprofilierung 38 integriert, gebildet aus einer alternierenden Abfolge von Vertiefungen 40 und gerundeten Erhebungen 42, wie vorstehend bereits beschrieben.

Der Darstellung gemäß Figur 6 ist des Weiteren zu entnehmen, dass in 180°-Anordnung 64 im Hülsenkäfig 62 einander gegenüberliegend besagte federbeaufschlagte Rastelemente 50, jeweils aufgenommen in Aufnahmehülsen 54 angeordnet sind. Die Oberseite des Gehäuses 24, welche an den Freiraum 70 zwischen dem verdrehbaren Wahlschalter 26 grenzt, ist mit einer leichten Wölbung 76 versehen, um eine geschmeidige Handhabung des elektronischen Messgerätes 10 bei Betätigung des verdrehbaren Wahlschalters 26 zu unterstützen.

Die Erfindung ist nicht auf die hier beschriebenen Ausführungsbeispiele und die darin hervorgehobenen Aspekte beschränkt. Vielmehr ist innerhalb des durch die Ansprüche angegebenen Bereichs eine Vielzahl von Abwandlungen möglich, die im Rahmen fachmännischen Handelns liegen.

## Patentansprüche

1. Elektronisches Messgerät (10) mit einem um eine Drehachse (30) verdrehbaren Wahlschalter (26) zur Auswahl der Betriebsmodi, der auf einem Zapfen (36) in einem Gehäuse (24) aufgenommen ist und mit federbeaufschlagten Rastelementen (50) versehen ist, die den verdrehbaren Wahlschalter (26) in einer einem ausgewählten Betriebsmodus entsprechenden Drehlage temporär arretieren, **dadurch gekennzeichnet, dass** die federbeaufschlagten Rastelemente (50) im Gehäuse (24) des elektronischen Messgeräts (10) in Horizontallage (60) angeordnet sind.

2. Elektronisches Messgerät (10) gemäß Anspruch 1, **dadurch gekennzeichnet, dass** die federbeaufschlagten Rastelemente (50) radial an eine Innenprofilierung (38) des verdrehbaren Wahlschalters (26) angestellt sind.

3. Elektronisches Messgerät (10) gemäß Anspruch 1, **dadurch gekennzeichnet, dass** die federbeaufschlagten Rastelemente (50) radial an eine am Außenumfang (37) der Hülse (35) ausgebildete Profilierung (34) angestellt sind.

4. Elektronisches Messgerät (10) gemäß den Ansprüchen 1 bis 3, **dadurch gekennzeichnet, dass** die federbeaufschlagten Rastelemente (50) in Aufnahmehülsen (54) eingelassen sind, die im Gehäuse (24) in einem Hülsenkäfig (62) aufgenommen sind.

5. Elektronisches Messgerät (10) gemäß den Ansprüchen 1 bis 4, **dadurch gekennzeichnet, dass** die federbeaufschlagten Rastelemente (50) als Arretierkugeln ausgeführt sind.

6. Elektronisches Messgerät (10) gemäß den Ansprüchen 1 bis 2, **dadurch gekennzeichnet, dass** die Innenprofilierung (38) des verdrehbaren Wahlschalters (26) in alternierender Abfolge angeordnete Vertiefungen (40) und gerundete Erhebungen (42) aufweist.

7. Elektronisches Messgerät (10) gemäß den Ansprüchen 1 bis 6, **dadurch gekennzeichnet, dass** zwischen dem verdrehbaren Wahlschalter (26) und dem Gehäuse (24) eine Labyrinthdichtung (56) ausgeführt ist.

8. Elektronisches Messgerät (10) gemäß Anspruch 7, **dadurch gekennzeichnet, dass** die Labyrinthdichtung (56) mindestens eine gehäuseseitige, ringförmige Kriechstrecke (72) und mindestens eine wahlschalterseitige, ringförmige Kriechstrecke (74) aufweist, deren Umfangsflächen, bezogen auf die Drehachse (30) des Wahlschalters (26), geneigt ausgeführt sind.

9. Elektronisches Messgerät (10) gemäß Anspruch 8, **dadurch gekennzeichnet, dass** zumindest der gehäuseseitigen Kriechstrecke (72) eine ringförmige Dichtung (66) zugeordnet ist.

10. Elektronisches Messgerät (10) gemäß den Ansprüchen 1 bis 2 und 4 bis 9, **dadurch gekennzeichnet, dass** die Innenprofilierung (38) in die wahlschalterseitige Kriechstrecke (74) des verdrehbaren Wahlschalters (26) integriert ist.

11. Elektronisches Messgerät (10) gemäß den Ansprüchen 1 bis 10,
**dadurch gekennzeichnet, dass** gehäuseseitig zumindest zwei einander in 180°-Anordnung (64) gegenüberliegende federbeaufschlagte Rastelemente (50) vorgesehen sind.

12. Elektronisches Messgerät (10) gemäß einem der Ansprüche 1 bis 11, **dadurch gekennzeichnet, dass** dieses als Multimeter, als Zangenamperemeter, als Gabelamperemeter oder als Spannungsmesser zur Messung elektrischer Größen, insbesondere Ströme, Spannungen, ohmsche Widerstände, Kapazitäten, Temperaturen und/oder Impedanzen in Gleichstrom- oder Wechselstromanwendungen ausgeführt ist.
